# NEUE EUROPÄISCHE PATENTSCHRIFT

(11) **EP 3 094 800 B2**
(45) Veröffentlichungstag und Bekanntmachung des Hinweises auf die Entscheidung über den Einspruch: **04.05.2022**
(45) Hinweis auf die Patenterteilung: 26.09.2018
(21) Anmeldenummer: 15709823.7
(22) Anmeldetag: 15.01.2015
(51) Int. Cl.: E05B 81/54

(54) **SEITENTÜRSCHLOSS FÜR EIN KRAFTFAHRZEUG**
SIDE-DOOR LOCK FOR A MOTOR VEHICLE
SERRURE DE PORTIÈRE LATÉRALE DE VÉHICULE À MOTEUR

(30) Priorität: 15.01.2014 DE 102014000294
(43) Veröffentlichungstag der Anmeldung: 23.11.2016
(73) Patentinhaber: Kiekert AG, 42579 Heiligenhaus (DE)
(72) Erfinder: MAZAL, Radek, 51745 Chleny (CZ); ZEJDA, Jan, 53701 Chrudim (CZ)
(86) Internationale Anmeldenummer: PCT/DE2015/100022
(87) Internationale Veröffentlichungsnummer: WO 2015/106761

(56) Entgegenhaltungen:
- EP-A2- 1 087 082
- EP-A2- 1 284 333
- WO-A1-2005/012676
- DE-A1-102012 211 756
- DE-U1-202008 015 696
- JP-B2- H0 826 710
- US-A- 5 360 351

## Beschreibung

Die Erfindung betrifft ein Kraftfahrzeugschloss, dass zumindest einen Elektrokomponententräger umfasst, wobei der Elektrokomponententräger als modulares Element ausgebildet ist und mindestens eine Leiterbahn, einen Schalter und optional ein weiteres Bauelement umfasst.

Zur Stromversorgung elektrischer Komponenten wie beispielsweise eines Elektromotors und/oder eines Mikroschalters, ist es bekannt, elektrische Leiterbahnen in ein Schlossgehäuse eines Seitentürschlosses für ein Kraftfahrzeug zu integrieren. Ein elektrische Leiterbahnen umfassendes Kunststoffgehäuseteil wird dabei als Elektrokomponententräger (EKT) bezeichnet. Aus dem Elektrokomponententräger weisen zumeist elektrische Kontakte heraus, sodass die elektrischen Bauteile adaptierbar sind.

Die im Folgenden beschriebenen und bekannten Lösungen beziehen sich beispielhaft auf eingesetzte Elektrokomponententräger und/oder Trägerplatten, die in Kraftfahrzeugschlössern verbaut werden.

Zum Stand der Technik gehört hierbei eine Trägerplatte, die aus der Druckschrift DE 20 2006 011 116 U1 bekannt ist. Die Druckschrift zeigt eine Trägerplatte, die mit mehreren Elektrokomponenten wie beispielsweise Leiterbahnen und Schaltern versehen ist, welche zusammen mit einer Trägerplatte in einer kompakten modularen Bauweise in ein Schlossgehäuse eingefügt wird. Dabei ist die Trägerplatte zusammen mit ihren elektrischen Leiterbahnen einstückig, insbesondere als ein Kunststoff-Spritzgussteil, ausgebildet. Außerdem ist die Trägerplatte ein Bestandteil des Kraftfahrzeugschlossgehäuses.

Darüber hinaus ist durch die DE 10 2009 053 384 A1 ein Kunststoffträger bekannt geworden, auf dem elektrische Bauteile angebracht sind. Dieser Kunststoffträger bildet ebenso einen Teil des Schlossgehäuses. Genauer gesagt, ist dieser Kunststoffträger als eine Gehäusehälfte beziehungsweise als ein Gehäuseoberteil eines Schlosses ausgebildet.

Bekannt ist ebenfalls aus der DE 10 2006 037 159 B4 ein Elektrokomponententräger, der einen Teil eines Schlossgehäuses bildet.

Aus der EP 1 087 082 A2 ist ein Kraftfahrzeugschloss mit einem modularen Elektro-komponententräger, der ein separates Gehäuse sowie eine Leiterbahn und ein Schaltmittel umfasst und an einer äußeren Oberfläche des Kraftfahrzeugschlosses befestigbar ist bekannt. Ebenso ist aus der WO 2005/012676 A1 ein Kraftfahrzeugschloss bekannt, das ein Grundgehäuse, das zur Aufnahme eines Ergänzungsmoduls mit separatem Gehäuse , welches einen Motor umfasst, aufweist.

Der gattungsbildende Stand der Technik nach den oben genannten Dokumenten stößt dann an Grenzen, wenn es darum geht ein Schlossgehäuse kostengünstig und adaptiv zu gestalten und trotzdem auf komplexe und aufwendig herzustellende Elektrokomponententräger verzichtet werden soll.

Der Erfindung liegt das technische Problem zugrunde, dass der Elektrokomponententräger in der Herstellung ein sehr aufwendiges Bauteil ist. Einerseits weist der Elektrokomponententräger zusätzlich zumeist eine hohe Anzahl an elektrischen Komponenten auf, die zum Teil sehr empfindlich sind und andererseits muss für die Aufnahme und Ausrichtung der Leiterbahnen zumeist auf mehrere Fertigungsschritte zurückgegriffen werden. Die elektrischen Komponenten müssen zumeist in mehreren Arbeitsschritten in das vornehmlich aus Kunststoff gespritzte Schlossgehäuse eingefügt werden. Ein Austausch von defekten elektrischen Komponenten des Schlosses ist in vielen Fällen unmöglich oder sehr aufwendig und teuer. Ebenso muss bei jedem neu entwickelten Schloss ein individuell anzupassender Komponententräger mit elektrischen Elementen erstellt werden. Zur Lösung dieser Aufgabe schlägt die Erfindung einen modularen Elektro-komponententräger für Kraftfahrzeugschlösser vor, der ein separates Gehäuse umfasst und an einer äußeren Oberfläche des Schlossgehäuses des Kraftfahrzeugschlosses befestigbar ist und der Steckkontakte umfasst, die aus dem Elektrokomponententräger herausragen, wobei die Steckkontakte unmittelbar mit einem Motor kontaktiert werden können. Dieser Elektrokomponententräger ist insofern vorteilhaft, da er eine kompakte unabhängige Bauei nheit bildet, die elektrische Komponenten wie beispielsweise Leiterbahnen, Schalter, Kontakte und andere Bauteile umfasst. Somit entfallen elektrische Leiterbahnen sowie andere elektrische Komponenten im Schlossgehäuse. Stattdessen werden die elektrischen Leitungen, Schaltmittel und Elemente in den modularen Elektrokomponententräger eingebaut. Über elektrische Kontakte am modularen Elektrokomponententräger wird dann ein Elektromotor direkt kontaktiert. Ein möglicher Mikroschalter wird in diesem Elektrokomponententräger eingebaut und derart in das Gehäuse vom Elektrokomponententräger und in die Bereiche der zu kontaktierenden Elemente platziert, dass zum Beispiel ein Schalten eines Mikroschalters ermöglicht wird. Ebenso sind die Fertigungskosten für das Schloss sehr gering, weil die Leiterbahnen im Schlossgehäuse entfallen.
Der modulare Elektrokomponententräger kann auch in einer weiteren Ausführungsform mit Stecker und/oder Steckdose ausgebildet sein, so dass ein unmittelbares Kontaktieren erleichtert wird. Darüber hinaus bietet die Möglichkeit der Ausbildung eines Steckers und/oder einer Steckdose ein stabiles Positionieren des modularen Elektrokomponententrägers am Schlossgehäuse. Außerdem ist solch ein zwischengeschalteter Stecker vorteilhaft, wenn es um die Adaptierung verschiedener elektrischer Systeme geht. So ist in dieser Ausführung beispielsweise die Möglichkeit geboten, das man anstatt von einzelnen Leitungsdrähten auch Stecker oder Anschlüsse mit Kabelbäumen anbindet.
Das Gehäuse des Elektrokomponententrägers kann einstückig aus Kunststoff gespritzt und mit Versteifungen ausgebildet sein, so dass empfindliche elektrische Bauteile, wie Leiterbahnen, Stanzgitter, LEDs und Schalter vor äußeren Einflüssen geschützt sind. Fertigungstechnisch werden vornehmlich die Leiterbahnen des Elektrokomponententrägers mit einer Trägerplatte vereinigt und zusammen mit dem Kunststoffgehäuse in einem Spritzgussverfahren gefügt. An diese Trägerplatte, die das Gehäuse des Elektrokomponententrägers bildet können dann elektrische Leiterbahnen und/oder je nach Ausführungsform elektrische Komponenten angeschlossen oder adaptiert werden. Somit ist ein modularer Elektrokomponententräger erzielbar, was wiederum einen Vorteil in Bezug auf Wartungs- und Instandsetzungsarbeiten darstellt, weil anfallende Zeit- und Reparaturkosten durch einen günstigen Austausch minimiert werden. Vorstellbar ist es darüber hinaus auch und stellt ebenfalls einen Vorteil der Erfindung dar, dass der gesamte Elektrokomponententräger austauschbar ist.

Die äußere Oberfläche des Kraftfahrzeugschlosses ist entsprechend zugänglich ausgebildet, so dass an die äußere Oberfläche ein Elektrokomponententräger adaptierbar ist. Insbesondere kann so eine Oberfläche aus zwei Sockeln bestehen, die aus dem Gehäuse des Elektrokomponententrägers heraus ragen. Diese Sockel bieten durch ihre Ausbildung entsprechend angepasst an den Elektrokomponententräger eine Abstützung, wodurch der Elektrokomponententräger eine verbesserte Stabilität erfährt. Gleichzeitig bilden die Sockel Führungen für zum Beispiel Steckkontakte. Die Abstützung erfolgt dann im Rahmen einen Formschlusses zwischen Elektrokomponententräger und dem Gehäuse des Kraftfahrzeugschlosses.

Des Weiteren lässt sich ein Vorteil der Erfindung dadurch herstellen, dass der Elektro-komponententräger mit einer Leiterbahn und einem Schaltmittel und optional einem weiteren elektrischen Bauelement einstückig ausgebildet ist. Es ist beispielsweise eine Trägerplatte vorstellbar, auf der mehrere elektrische Komponenten durch beispielsweise Anlöten angebracht sind. Das Gehäuse kann dann in einem Spritzgussverfahren mit einem Kunststoff gefüllt sein, so dass die elektrischen Komponenten zum Beispiel vor Feuchtigkeit und Erschütterungen geschützt sind. Hierdurch wird eine untrennbare Einheit gebildet, die erfindungsgemäß als einstückiger Aufbau definiert wird. Die empfindlichen elektrischen Komponenten sind dank des Gehäuses und dem Verbund des Aufbaus optimal vor äußeren Einwirkungen wie Stößen geschützt und erhalten dank der festen Verbindung eine Stabilität und/oder Steifigkeit, wodurch letztlich die Lebensdauer des Elektrokomponententrägers verlängert wird.

Erfindungsgemäß ist ein Schaltmittel im Elektrokomponententräger derart angeordnet, dass das Schaltmittel aus dem Gehäuse des Elektrokomponententrägers hinaus ragt und das Gehäuse des Kraftfahrzeugschlosses hinein reicht, so dass das Schaltmittel mit mechanischen Bauteilen zusammenwirkt. Bei dem Schaltmittel kann es sich beispielsweise um einen Mikroschalter handeln, der mit mechanischen Bauteilen im Schloss wie zum Beispiel einer Drehfalle oder einem anderen Hebel in Kontakt steht. Somit ist auch hier ein unmittelbares Erfassen eines Zustands und/oder einer Lage eines bewegten Bauteils des Kraftfahrzeugschlosses ermöglicht.

Ebenso kann es von Vorteil sein, dass der Elektrokomponententräger mit wenigstens einem Haltemittel des Gehäuses des Kraftfahrzeugschlosses zusammenwirkt. Dadurch wird ein unerwünschtes Lösen des Elektrokomponententrägers vom Kraftfahrzeugschlossgehäuse verhindert. Durch das eine oder die zwei oder mehreren Haltemittel ist der Elektrokomponententräger am Kraftfahrzeugschlossgehäuse fixierbar. Eine sichere Übertragung elektrischer Signale kann unter Verhinderung von Wackelkontakten realisiert werden. Unter Haltemittel werden zum Beispiel formschlüssige Verbindungen in Form von Rastnasen, Haken oder Klammern verstanden, die aus separaten Elementen oder einstückig mit dem Elektrokomponententräger und/oder dem Gehäuse des Kraftfahrzeugschlosses ausgebildet sind. Darüber hinaus ist es erfindungsgemäß vorstellbar den Elektrokomponententräger mit dem Gehäuse des Kraftfahrzeugschlosses zu verschrauben oder zu vernieten. Denkbar sind auch Klebstoffe oder Schweißnähte, die vor der Erstarrung beziehungsweise Abkühlung oder Trocknung einen flüssigen Zustand aufweisen.

Darüber hinaus kann sich ein Vorteil daraus ergeben, dass das Haltemittel mit dem Elektrokomponententräger aus einer kraftschlüssigen und/oder formschlüssigen Verbindung besteht. Unter einer kraftschlüssigen Verbindung kann man sich Klemmen, Keile oder Schraubverbindungen vorstellen, die den Elektrokomponententräger mit dem Schlossgehäuse verbinden. Schraubenverbindungen zählen ebenfalls zusammen mit den Niet- und Stiftverbindungen zu den formschlüssigen Verbindungen. Die physikalischen Wirkprinzipien dieser Verbindungsarten können individuelle Vorteile bieten. So sind beispielsweise Schraubverbindungen gut lösbar und auf viele Beanspruchungsarten wie Torsion, Zug, Scherung und Biegung auslegbar. Bei Stift- und Bolzenverbindungen wird dagegen ein unbeabsichtigtes Losdrehen verhindert.

Insbesondere ergeben sich Vorteile daraus, dass die Haltemittel als Clip-, Schnapp- und/oder Rastverbindungen, und/oder Schraubenverbindungen, und/oder Bolzen- und/oder Nietverbindungen ausgebildet sind. Clip-, Schnapp- oder Rastverbindungen sind günstig, weil sie unmittelbar als Bereiche beziehungsweise Elemente des Schlossgehäuses ausgebildet sein können. Sie werden somit im Herstellungsvorgang des Schlossgehäuses wie beispielsweise beim Kunststoffspritzguss ausgebildet. Daraus ergeben sich Zeit- und Kostenvorteile bezüglicher der Fertigung.

Optional kann auch das Gehäuse des Elektrokomponententrägers mit Clip-, Schnapp- oder Rasthilfsmitteln ausgebildet sein. Schrauben bieten wie bereits erwähnt Vorteile bezüglich hoher Belastbarkeit und vor allem flexibler Montage. Bolzen und Stiftverbindung sind Verbindungsmittel, die die höchsten Beanspruchungen verkraften können. In der vorgestellten Erfindung sind die Hilfsmittel als Klemmen beziehungsweise Schnappverbindungen ausgebildet, die einen Teil des Schlossgehäuses bilden und das Elektrokomponentengehäuse am Umfang umgreifen und festhalten. Ein Verbindungspartner ist entsprechend der Form des jeweiligen Verbindungspartners ausgebildet um mit seinem Verbindungspartner optimal zusammenzuwirken.

Darüber hinaus ist es von Vorteil, dass das Gehäuse des Elektrokomponententrägers aus Kunststoff ausgebildet ist. Die Materialkosten sind aufgrund des Kunststoffwerkstoffs gering und die Trägerplatte mit elektrischen Komponenten kann in einem Spritzgussvorgang gut in das Gehäuse eingefügt oder integriert werden. Außerdem weist das Gehäuse des Elektrokomponententrägers durch den Kunststoff ein geringeres Gewicht auf, als ein vergleichbares metallisches Werkstoffgehäuse. Des Weiteren ist das Kunststoffgehäuse soweit vorteilhaft, weil der Kunststoff in der Formungsphase mit Haltemitteln und anderen nützlichen Elementen ausgebildet werden kann.
Außerdem umfasst der Elektrokomponententräger zumindest einen Anschluss, insbesondere einen Steckkontakt für eine Elektronik und/oder eine Steuerung. Eine gewisse Anzahl an Anschlüssen am Elektrokomponententräger bietet eine Vielzahl an Möglichkeiten beziehungsweise Schnittstellen, um andere elektrische Einheiten wie zum Beispiel eine Steuereinheit anzuschließen. Diese Schnittstellen sind als Steckkontakte ausgebildet, die mit anderen Kontakten kontaktieren. Dadurch können Steckkontakte am Schlossgehäuse selbst entfallen, was zu einer Fertigungskostenreduzierung führt.
Insbesondere ergibt sich ein Vorteil dadurch, dass es sich bei den Steckkontakten des Elektrokomponententrägers vor allem um Kontaktfahnen handelt, die aus dem Elektrokomponententräger herausrage. Dabei können die Kontaktfahnen zum Beispiel unmittelbar mit einer elektrischen Komponente im Kraftfahrzeugschloss, wie beispielsweise einem Motor, kontaktiert werden. Die Steckkontakte erstrecken sich dabei ausgehend von dem Elektrokomponententräger bis in das Kraftfahrzeugschloss hinein, so dass die elektrischen Komponenten unmittelbar kontaktiert werden können. Aufgrund der Erstreckung der Steckkontakte, besitzt der Elektrokomponententräger eine hohe Reichweite und erreicht somit sicher Komponenten im Kraftfahrzeugschloss wie beispielsweise einen Elektromotor. Die Kontaktfahnen können durch Sockel des Schlossgehäuses in das Schlossgehäuse hinein reichen, wobei die Sockel dem Elektrokomponententräger Stabilität bieten. Ebenso schützen die Sockel die Kontaktfahnen vor äußeren Einflüssen wie Beschädigung oder Korrosion. Das Kraftfahrzeugschlossgehäuse kann dabei ohne Leiterbahnen ausgebildet werden, was zu Kosteneinsparungen maßgeblich beiträgt, da die notwendigen Leiterbahnen bereits im Elektrokomponententräger ausgebildet sind.

Im Folgenden wird die Erfindung anhand von Zeichnungen näher erläutert. Es zeigen:

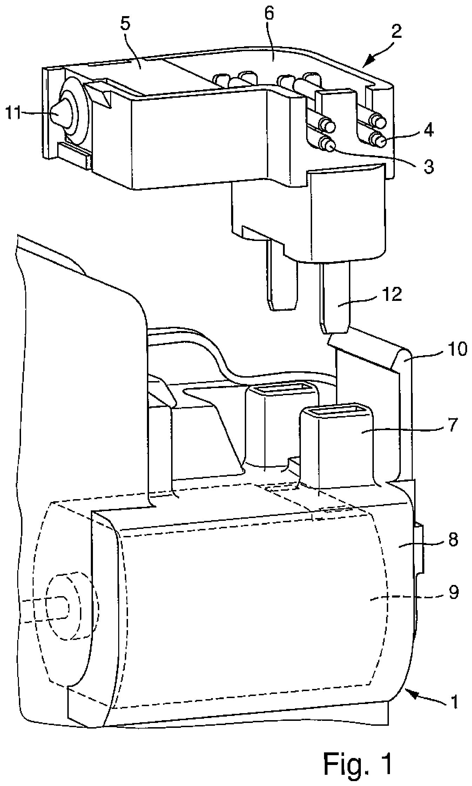

- **Fig. 1**: eine dreidimensionale Ansicht eines Elektrokomponententrägers in einer ersten Ausführungsform, sowie einen Teil des Schlossgehäuses vor dem Einbau des Elektrokomponententrägers,
- **Fig. 2**: eine dreidimensionale Ansicht des Elektrokomponententrägers in einer ersten Ausführungsform, sowie einen Teil des Schlossgehäuses im Einbauzustand des Elektrokomponententrägers,
- **Fig. 3**: eine dreidimensionale Ansicht einer weiteren Ausführungsform eines Elektrokomponententrägers, sowie einen Teil des Schlossgehäuses vor dem Einbau des Elektrokomponententrägers und
- **Fig. 4**: eine dreidimensionale Ansicht des Elektrokomponententrägers in einer zweiten Ausführungsform, sowie einen Teil des Schlossgehäuses im Einbauzustand des Elektrokomponententrägers.

Der modulare Elektrokomponententräger 2 weist in allen Figuren ein entsprechend kompakt ausgebildetes Gehäuse 6 auf. Das Gehäuse 6 besteh aus Kunststoff und weist einen ausreichend großen Bauraum auf, so dass elektrische Komponenten eingesetzt werden können. In allen Zeichnungen ist dieser Bauraum offen dargestellt, jedoch kann der Bauraum auch eine Abdeckung zum Schutz später enthalten oder mittels eines Vergießens verschlossen sein. Diese möglichen Abdeckungen sind nicht in den Zeichnungen dargestellt. Im Bauraum sind ein Schalter 5 mit elektrischem Kontakt 11 sowie beispielhaft einige elektrische Leiterbahnen 3 und 4 gezeigt. Der Elektrokomponententräger 2 weist Steckkontakte 12 auf, die aus einer Verlängerung des Elektrokomponententrägers 2 herausragen. Dabei weisen die Steckkontakte 12 in Richtung des Schlossgehäuses 8 beziehungsweise einer Oberfläche 7 des Schlossgehäuses 8 des Kraftfahrzeuges.

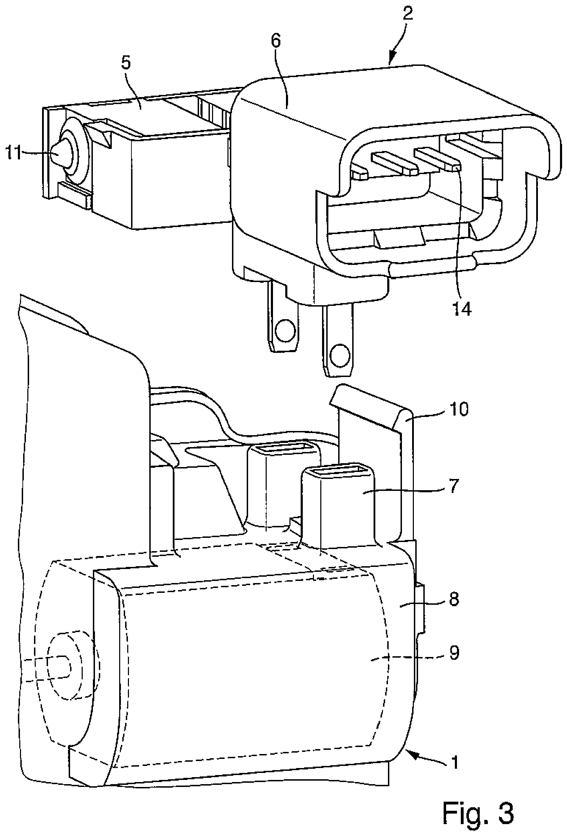

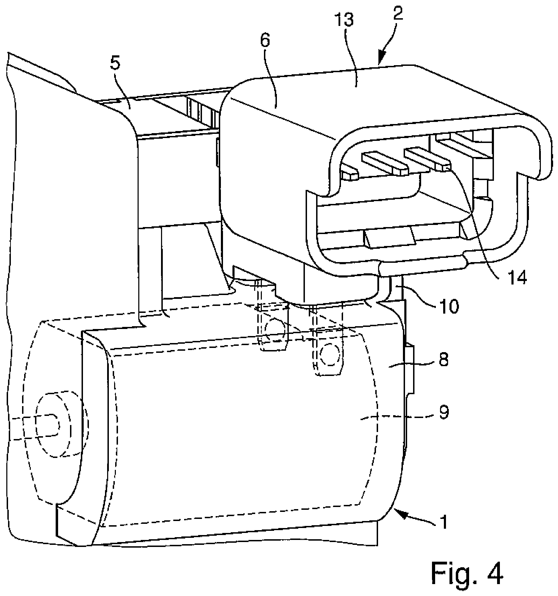

In den Figuren 3 und 4 ist der Elektrokomponententräger 2 in einer zweiten Ausführungsform mit einer zusätzlichen Funktion als Zwischenmittel 13 dargestellt. Dieses Zwischenmittel 13 beinhaltet ebenso Steckkontakte 14 und alle zuvor aufgeführten Bauelemente. Die zusätzlichen Steckkontakte 14 zeigen dabei seitlich aus dem Elektrokomponententrägergehäuse 6 heraus. In der Positionierung der beiden Ausführungsvarianten in Bezug auf die Anordnung zum Schlossgehäuse 8 zum Elektrokomponententräger 2 bestehen keine Unterschiede.

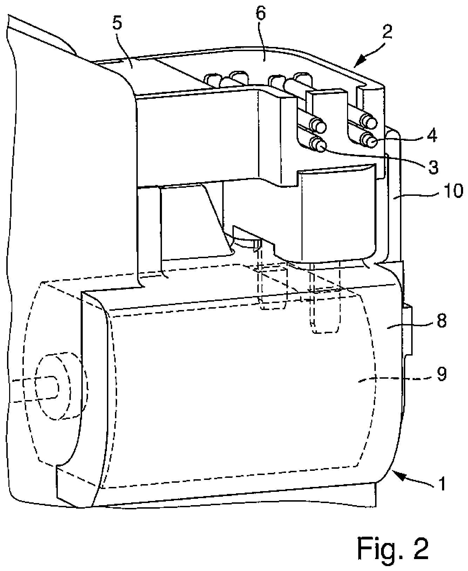

Unterhalb des Elektrokomponententrägers 2 ist das Schloss 1 positioniert. Hierbei wird ein Teil des Schlossgehäuses 8 gezeigt, wobei das Schlossgehäuse 8 diverse Bauelemente beinhaltet. Im Schlossgehäuse 8 ist ein elektromechanisches Bauteil angedeutet. Bei diesem Bauteil handelt es sich um einen Elektromotor 9, der an seinem vorderen Ende eine Motorwelle und an seinem hinteren Ende Kontakte aufweist. Diese Kontakte stehen im eingebauten Zustand mit den Steckkontakten 12 in Verbindung. In den Figuren 2 und 4 wird der Einbauzustand gezeigt wie der Elektrokomponententräger 2 mit seinen Steckkontakten 12 den Elektromotor 9 über seine Kontakte kontaktiert.

Darüber hinaus ist das Schlossgehäuse 8 mit einem Aufbau versehen, wobei der Aufbau eine Oberfläche sowie Haltemittel 10 umfasst. In diesem Ausführungsbeispiel besteht die Oberfläche des Schlossgehäuses 8 aus zwei Sockeln 7, wobei die Sockel 7 die Einführung der Steckkontakte 12 erleichtern sollen und zusätzlich den Steckkontakten 12 sowie dem modularen Elektrokomponententräger 2 eine stabile Abstützung und Schutz im eingebauten Zustand bieten.

Um ein Loslösen des Elektrokomponententrägers 2 vom Schloss 1 zu verhindern, ist das Schlossgehäuse 8 in dieser Ausführung mit einer Schnappverbindung als Haltemittel 10 ausgebildet. Dieses Haltemittel 10 hält den Elektrokomponententräger 2 im eingebauten Zustand durch eine kraft-/formschlüssige Verbindung fest, indem die Haltemittel 10 das Gehäuse 6 des Elektrokomponententrägers 2 umgreifen und festhalten.

## Patentansprüche

1. Kraftfahrzeugschloss (1) umfassend mindestens einen Elektrokomponententräger (2), wobei der Elektrokomponententräger (2) als modulares Element ausgebildet ist und mindestens eine Leiterbahn (3), (4) und mindestens ein Schaltmittel (5) und optional ein weiteres elektrisches Bauelement und ein separates Gehäuse (6) umfasst und an einer äußeren Oberfläche (7) des Schlossgehäuses (8) des Kraftfahrzeugschlosses (1) befestigbar ist, **dadurch gekennzeichnet, dass** der Elektrokomponententräger (2) Steckkontakte (12) umfasst, die aus dem Elektrokomponententräger (2) herausragen, wobei die Steckkontakte (12) unmittelbar mit einem Motor (9) des Kraftfahrzeugschlosses (1) kontaktiert werden können, wobei zumindest ein Schaltmittel (5) des Elektrokomponententrägers (2) in das Gehäuse (8) des Kraftfahrzeugschlosses (1) hineinragt und mit mechanischen Bauteilen zusammenwirkt.

2. Kraftfahrzeugschloss (1) nach Anspruch 1, **dadurch gekennzeichnet, dass** der Elektrokomponententräger (2) mit elektrischen Bauteilen versehen ist, insbesondere einer Leiterbahn (3), (4) und/oder einem Schaltmittel (5) und/oder weiterem elektrischen Bauelement, und einstückig ausgebildet ist.

3. Kraftfahrzeugschloss (1) nach einem der Ansprüche 1 bis 2, **dadurch gekennzeichnet, dass** der Elektrokomponententräger (2) mit Haltemitteln (10) des Gehäuses (8) des Kraftfahrzeugschlosses (1) zusammenwirkt.

4. Kraftfahrzeugschloss (1) nach Anspruch 3, **dadurch gekennzeichnet, dass** das Haltemittel (10) mit dem Elektrokomponententräger (2) aus einer kraft- und/oder formschlüssigen Verbindung besteht.

5. Kraftfahrzeugschloss (1) nach Anspruch 4, **dadurch gekennzeichnet, dass** die Haltemittel (10) aus mindestens jeweils einer als Clip-, Schnapp- und/oder Rastverbindung, und/oder Schraubenverbindung, und/oder Bolzenverbindung und/oder Nietverbindung ausgebildet ist.

6. Kraftfahrzeugschloss (1) nach einem der Ansprüche 1 bis 5, **dadurch gekennzeichnet, dass** das Gehäuse (6) des Elektrokomponententrägers (2) aus einem Kunststoff besteht.

7. Kraftfahrzeugschloss (1) nach den Ansprüchen 1 bis 6, **dadurch gekennzeichnet, dass** der Elektrokomponententräger (2) zumindest einen Anschluss, insbesondere einen Steckkontakt (12), (14), für eine Elektronik und/oder eine Steuerung umfasst.

## Claims

1. Motor vehicle latch (1) comprising at least one electrical component carrier (2), the electrical component carrier (2) being designed as a modular element and comprising at least one conductor track (3), (4) and at least one switching means (5) and optionally a further electrical component and a separate housing (6), and being able to be fastened to an outer surface (7) of the latch housing (8) of the motor vehicle latch (1), **characterized In that** the electrical component carrier (2) comprises plug-in contacts (12) which protrude from the electrical component carrier (2), it being possible for the plug-In contacts (12) to be contacted directly with a motor (9) of the motor vehicle latch (1), at least one switching means (5) of the electrical component carrier (2) protruding into the housing (8) of the motor vehicle latch (1) and interacting with mechanical components.

2. Motor vehicle latch (1) according to claim 1, **characterized in that** the electrical component carrier (2) is provided with electrical components, in particular a conductor track (3), (4) and/or a switching means (5) and/or a further electrical component, and is formed as a single piece.

3. Motor vehicle latch (1) according to either claim 1 or claim 2, **characterized in that** the electrical component carrier (2) interacts with holding means (10) of the housing (8) of the motor vehicle latch (1).

4. Motor vehicle latch (1) according to claim 3, **characterized In that** the holding means (10) together with the electrical component carrier (2) consists of a frictional and/or form-fitting connection.

5. Motor vehicle latch (1) according to claim 4, **characterized in that** the holding means (10) is formed from at least one clip, snap and/or latching connection and/or screw connection and/or bolt connection and/or rivet connection.

6. Motor vehicle latch (1) according to any of claims 1 to 5, **characterized in that** the housing (6) of the electrical component carrier (2) consists of a plastics material.

7. Motor vehicle latch (1) according to claims 1 to 6, **characterized in that** the electrical component carrier (2) comprises at least one connection, in particular a plug-in contact (12), (14), for electronics and/or a controller.

## Revendications

1. Serrure de véhicule automobile (1) comprenant au moins un support de composants électriques (2), le support de composants électriques (2) étant conçu comme un élément modulaire et comprenant au moins une piste conductrice (3), (4) et au moins un moyen de commutation (5) et éventuellement un autre composant électrique et un boitier séparé (6), et pouvant être fixé à une surface extérieure (7) du boîtier de serrure (8) de la serrure de véhicule automobile (1), **caractérisée en ce que** le support de composants électriques (2) comprend des contacts enfichables (12) qui font saillie depuis le support de composants électriques (2), les contacts enfichables (12) pouvant être mis en contact directement avec un moteur (9) de la serrure de véhicule automobile (1), au moins un moyen de commutation (5) du support de composants électriques (2) faisant saillie dans le boîtier (8) de la serrure de véhicule automobile (1) et coopérant avec des composants mécaniques.

2. Serrure de véhicule automobile (1) selon la revendication 1, **caractérisée en ce que** le support de composants électriques (2) est pourvu de composants électriques, en particulier d'une piste conductrice (3), (4) et/ou d'un moyen de commutation (5) et/ou d'un autre composant électrique, et est formé d'un seul tenant.

3. Serrure de véhicule automobile (1) selon l'une des revendications 1 à 2, **caractérisée en ce que** le support de composants électriques (2) coopère avec des moyens de maintien (10) du boîtier (8) de la serrure de véhicule automobile (1).

4. Serrure de véhicule automobile (1) selon la revendication 3, **caractérisée en ce que** le moyen de maintien (10) avec le support de composants électriques (2) consiste en une liaison à force et/ou par complémentarité de forme.

5. Serrure de véhicule automobile (1) selon la revendication 4, **caractérisée en ce que** les moyens de maintien (10) sont respectivement conçus comme au moins une liaison par clip, par encliquetage et/ou par enclenchement et/ou comme une liaison par vissage et/ou comme une liaison par boulonnage et/ou comme une liaison par rivetage.

6. Serrure de véhicule automobile (1) selon l'une des revendications 1 à 5, **caractérisée en ce que** le boîtier (6) du support de composants électriques (2) est en matière plastique.

7. Serrure de véhicule automobile (1) selon les revendications 1 à 6, **caractérisée en ce que** le support de composants électriques (2) comprend au moins une connexion, en particulier un contact enfichable (12), (14) pour un dispositif électronique et/ou une commande.
